# EUROPEAN PATENT SPECIFICATION

(11) **EP 0 977 362 B1**
(45) Date of publication and mention of the grant of the patent: **09.10.2002**
(21) Application number: 98830467.1
(22) Date of filing: 30.07.1998
(51) Int. Cl.: H03K 5/00, H03K 5/156

(54) **Frequency doubler with 50% duty cycle output**
Frequenzverdoppler mit 50% Tastverhältnis am Ausgang
Doubleur de fréquence avec un rapport cyclique de sortie de 50%

(43) Date of publication of application: 02.02.2000
(73) Proprietor: STMicroelectronics S.r.l., 20041 Agrate Brianza (Milano) (IT)
(72) Inventor: Schwartz, Reiner, 85567 Grafing (DE)
(74) Representative: Pellegri, Alberto

(56) References cited:
- EP-A- 0 343 898
- FR-A- 2 222 799
- K. NAGARAJ, K. RAMKUMAR: "A frequency doubler for rectangular inputs." INTERNATIONAL JOURNAL OF ELECTRONICS, vol. 56, no. 3, 1884, pages 433-436, XP002084165 Basingstoke, GB
- PATENT ABSTRACTS OF JAPAN vol. 010, no. 302 (E-445), 15 October 1986 & JP 61 116416 A (NEC CORP;OTHERS: 01), 3 June 1986

## Description

### FIELD OF THE INVENTION

The present invention relates to digital circuits and more in particular to a circuit for doubling the frequency of a digital signal of a 50% duty cycle, typically of a clock signal.

### BACKGROUND

In digital processing circuitry, it is quite often required to double the frequency of a clock signal or more in general of a digital signal having a 50% duty cycle.

It is important to ensure that the output signal with double frequency retains a precise 50% duty cycle. In fact, the output signal is often used to derive an internal frequency of four times the frequency of the input signal and any deviation from a precise 50% duty cycle could induce an error in the higher frequency signals that may be derived therefrom.

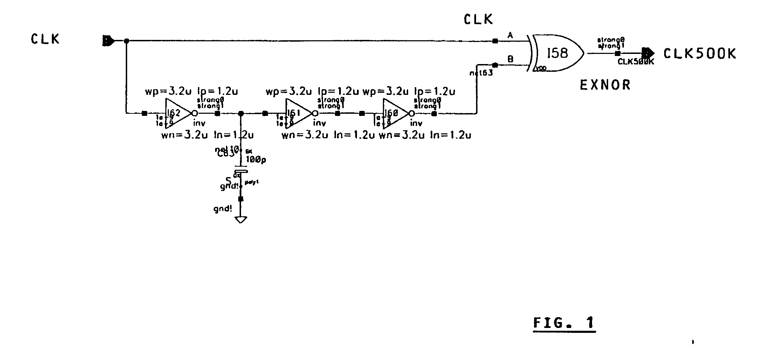

In Fig. 1 is shown a classical circuit used for doubling the frequency of an input signal with a 50% duty cycle.

Basically the circuit employs an EXNOR or an EXOR gate, to a first input of which is coupled the digital input signal CLK while at the second input of which is fed a replica of the input signal CLK delayed by a quarter of period by the use of a delay line including a cascade of three identical inverters and a capacitor connected between the coupling node of the output of the first inverter to the input of the second inverter and ground.

The delay introduced by the line must be exactly a quarter of the period time of the input signal CLK.

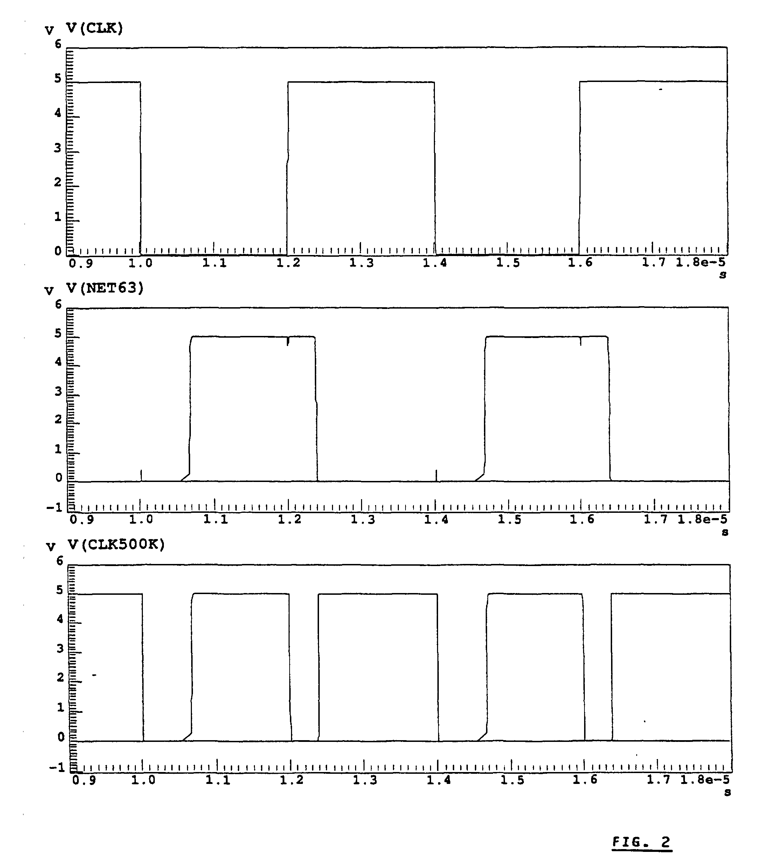

In Fig. 2 are shown the wave form of the signals, the output signal of the EXNOR gate employed being high when its two inputs are at different states.

Increasing frequencies of the processed digital signals and stricter requisites of precision of sampling frequencies, render difficult to ensure that the delay times of the components of the delay line of the classical scheme of Fig. 1 match exactly to provide for the required quarter of period time delay.

### OBJECT AND SUMMARY OF THE INVENTION

These difficulties of the known circuit are overcome by the circuit of this invention that reveals itself capable of ensuring a markedly enhanced precision of the 50% duty cycle of the output signal than it was possible with the known circuits, for the same fabrication technology.

Basically, the circuit of this invention relies on sensing, by the use of a comparator, when the voltage on a capacitor charged with a constant current during a phase of the input signal of 50% duty cycle reaches a half of its full charge swing. In view of the fact that half of the voltage of the charging process of the capacitor during one phase of the input signals of 50% duty cycle is reached at half the time interval of the charging phase, the comparator output switches at exactly a quarter of the period of the input signal.

Of course, instead of using a resistive voltage divider of the voltage present on the charging capacitor more advantageously, the latter may be made up of two capacitors of identical value connected in series, whereby the comparator may sense the voltage present on one of the two capacitors in series.

Constant current generator means and switch means controlled by the input signal and by its inverse signal or by functionally equivalent control signals, operatively provide for a linear charging of the capacitor or capacitors in series, during a first half period of the input signal and a complete discharge of the capacitor or of the capacitors in series during the following half period of the input signal, or anyhow after the switching of the half-swing sensing comparator.

Of course, the output gate that can be used may either be an EXNOR or an EXOR gate, as in a prior art circuit.

The capacitor charging and discharging circuit and the relative comparator may be "duplicated" according to a common dual architecture of digital circuitry.

### BRIEF DESCRIPTION OF THE DRAWINGS

The different aspects and advantages of the invention will become even clearer through the following description and illustrations of embodiments thereof and by referring to the attached drawings, wherein:
**Figure 1** shows a frequency doubler circuit according to a commonly known technique, as mentioned above;
**Figure 2** shows diagrams of the relevant signals of the known circuit of Fig. 1;
**Figure 3** is a basic diagram of a frequency doubler realized according to the present invention;
**Figure 4** is a detailed circuit diagram of the basic scheme of Fig. 3;
**Figure 5** shows the relevant signals of the circuit of Fig. 4.

### DESCRIPTION OF PREFERRED EMBODIMENTS

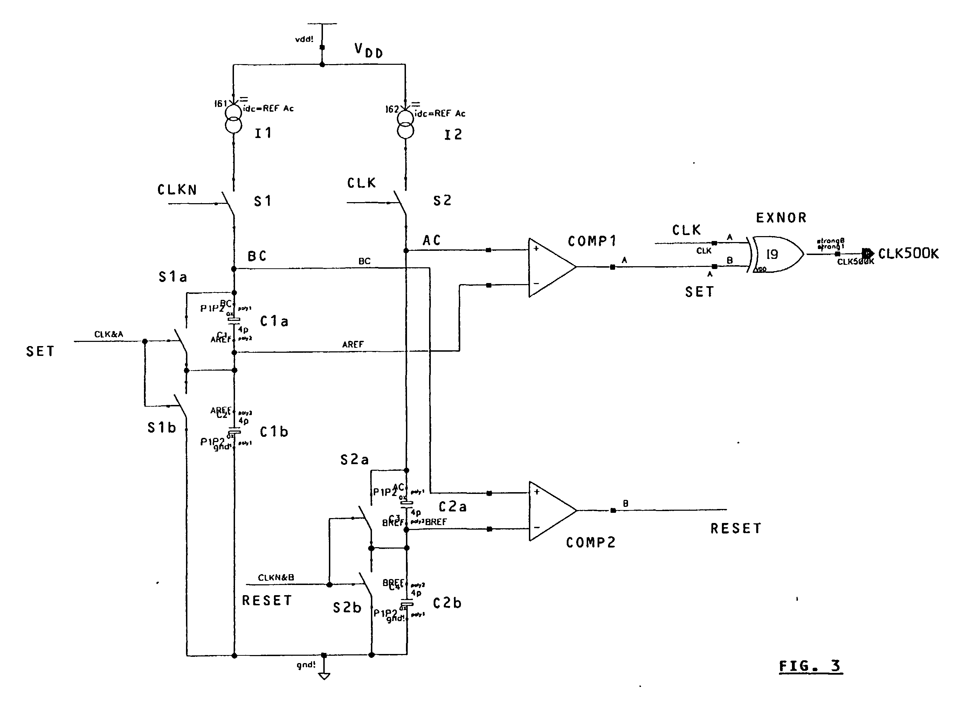

In figures 3 to 5, a dual implementation of the basic circuit of the invention is depicted for the sake of completeness without intending to limit its implementation to a dual form.

With reference to the basic scheme of Fig. 3, the first input of the EXNOR output gate is coupled to the input signal CLK while the second input is coupled to the output of the comparator COMP 1.

The comparator COMP 1 senses the voltage present on the capacitor C1a which has the same capacitance value of the capacitor C1b, connected in series thereto.

The capacitors in series C1a and C1b are charged with a constant current generated by the current generator I1 during one phase of the input signal CLK and are discharged during the successive phase of the input signal CLK.

The charging and discharging processes are controlled by the switches S1 and S1a and S1b.

A dual duplication of the circuit is constituted by the current generator I2, the capacitors in series C2a and C2b, that may have of the same capacitance value of the pair C1a and C1b, the switches S2, S2a and S2b and the comparator COMP2.

If the duty cycle of the input signals CLK is exactly 50%, and the current sources I1 and I2 are identical, the dual signals of opposite phase output by the comparators COMP1 and COMP2 will be exactly delayed by a quarter of the period time of the input signal CLK in respect of the corresponding transitions of the input signal CLK.

The signals output by the two comparators COMP1 and COMP2 may be conveniently used for controlling the switches.

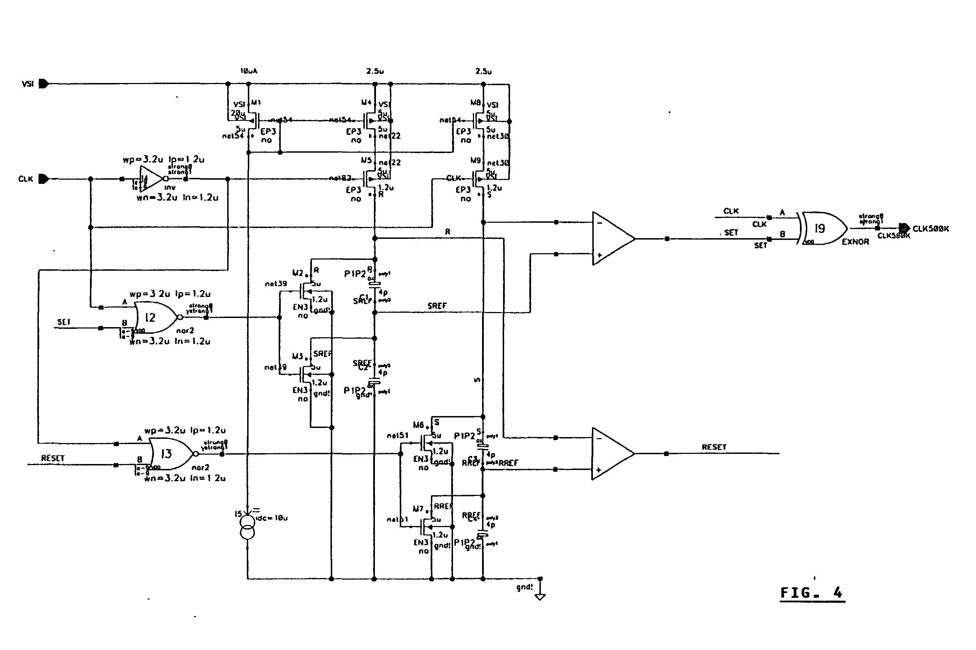

A circuit implementation of the basic circuit of Fig. 3 is shown in Fig. 4, illustrating also the drives that implement the switches that control the charging and discharging processes of the two pairs of capacitors in series.

Of course, instead of a pair of capacitors of equal value connected in series, a single capacitor may be employed and half of the voltage on it be sensed by the use of a resistive voltage divider functionally connected in parallel to the capacitor, according to a common arrangement.

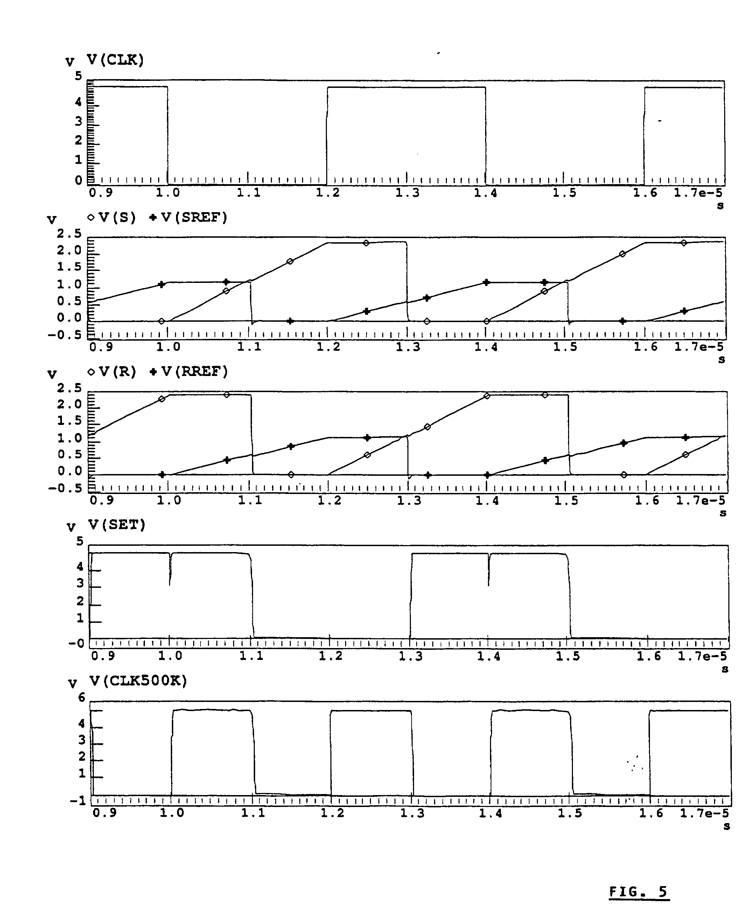

The relevant signals of the circuit of Fig. 4 are shown in the diagrams of Fig. 5.

Another possible alternative embodiment of the circuit of the invention may employ a single comparator instead of two comparators of the dual implementation of the circuit shown in Figures 3 and 4, by employing additional switches for switching the inputs of the single comparator on one or on the other sensing line, according to common switcheable configuration techniques of integrated circuits.

## Claims

1. A frequency doubler with a 50% duty cycle output employing a two-input EXOR or EXNOR gate, one input of which is coupled to a digital input signal of a first frequency (CLK) and the second input of which is coupled to a replica of said input signal, delayed by a quarter of the period of said input signal (CLK), **characterized by** comprising
at least a first capacitor (C1a, C1b), a constant current generator (I1) for charging said capacitor (C1a, C1b) during one of the two half periods of said input signal (CLK) and first (S1) and second (S1a, S1b) switch means, controlled in phase opposition by said input signal (CLK) and by an inverted signal thereof (CLKN) for charging and discharging said capacitor (C1a, C1b) during each period of said input signal;
voltage divider means halving the voltage present on said capacitor (C1a, C1b);
at least a comparator (COMP1) sensing said halved voltage and having an output coupled to said second input of said two-input gate.

2. The frequency doubler according to claim 1, wherein said voltage divider means are implemented by employing two capacitors in series of identical capacitance (C1a, C1b) charged and discharged by said constant current generator (I1) and switch means (s1, S1a, S1b), said comparator (COMP1) sensing the voltage on one (1a) of the two capacitors in series.

3. The frequency doubler according to claim 1, **characterized by** further comprising
a second capacitor (C2a, C2b), a second constant current generator (I2) for charging said second capacitor (2a, 2b) during one of the two half periods of said input signal (CLK) and third and fourth switch means (S2, S2a, S2b), controlled in phase opposition by said input digital signal (CLK) and by an inverted signal thereof (CLKN) for charging and discharging said second capacitor (C2a, C2b) during each period of said input signal;
second voltage divider means halving the voltage present on said second capacitor (C2a, C2b);
at least a second comparator (COMP2) sensing said halved voltage and outputting a logic control signal for said switch means.

## Patentansprüche

1. Frequenzverdoppler, der ein Ausgangssignal mit einem Tastgrad von 50 % besitzt und ein Doppeleingangs-EXOR- oder EXNOR-Gatter verwendet, wovon ein Eingang mit einem digitalen Eingangssignal einer ersten Frequenz (CLK) gekoppelt ist und ein zweiter Eingang mit einer Kopie des Eingangssignals, die um eine Viertelperiode des Eingangssignals (CLK) verzögert ist, gekoppelt ist, **gekennzeichnet durch**
wenigstens einen ersten Kondensator (C1a, C1b), einen Konstantstromgenerator (I1) zum Laden des Kondensators (C1a, C1b) während einer der beiden Halbperioden des Eingangssignals (CLK) und erste (S1) und zweite (S1a, S1b) Schaltmittel, die mit entgegengesetzter Phase **durch** das Eingangssignal (CLK) und **durch** ein invertiertes Signal hiervon (CLKN) gesteuert werden, um den Kondensator (C1a, C1b) während jeder Periode des Eingangssignals zu laden und zu entladen;
Spannungsteilermittel, die die am Kondensator (C1a, C1b) vorhandene Spannung halbieren;
wenigstens einen Komparator (COMP1), der die halbierte Spannung erfaßt und mit seinem Ausgang mit dem zweiten Eingang des Doppeleingangs-Gatters gekoppelt ist.

2. Frequenzverdoppler nach Anspruch 1, bei dem die Spannungsteilermittel durch Verwendung zweier in Reihe geschalteter Kondensatoren mit gleicher Kapazität (C1a, C1b), die durch den Konstantstromgenerator (I1) und die Schaltmittel (s1, S1a, S1b) geladen und entladen werden, verwirklicht sind, wobei der Komparator (COMP1) die Spannung an einem (1a) der beiden in Reihe geschalteten Kondensatoren erfaßt.

3. Frequenzverdoppler nach Anspruch 1, ferner **gekennzeichnet durch**
einen zweiten Kondensator (C2a, C2b), einen zweiten Konstantstromgenerator (I2) zum Laden des zweiten Kondensators (2a, 2b) während einer der beiden Halbperioden des Eingangssignals (CLK) und dritte und vierte Schaltmittel (S2, S2a, S2b), die in entgegengesetzter Phase **durch** das digitale Eingangssignal (CLK) und **durch** ein invertiertes Signal hiervon (CLKN) gesteuert werden, um den zweiten Kondensator (C2a, C2b) während jeder Periode des Eingangssignals zu laden und zu entladen;
zweite Spannungsteilermittel, die die über den zweiten Kondensator (C2a, C2b) liegende Spannung halbieren;
wenigstens einen zweiten Komparator (COMP2), der die halbierte Spannung erfaßt und ein logisches Steuersignal für die Schaltmittel ausgibt.

## Revendications

1. Doubleur de fréquence à rapport cyclique de sortie de 50% utilisant une porte à deux entrées Ou Exclusif ou NON OU Exclusif, dont une entrée est couplée à un signal d'entrée numérique d'une première fréquence (CLK) et dont la seconde entrée est couplée à une réplique du signal d'entrée retardée d'un quart de la période du signal d'entrée (CLK), **caractérisé en ce qu'**il comprend :
au moins un premier condensateur (C1a, C1b), un générateur de courant constant (I1) pour charger le condensateur (C1a, C1b) pendant l'une des deux demi-périodes du signal d'entrée (CLK) et des premier (S1) et second (S1a, S1b) moyens de commutation commandés en opposition de phase par le signal d'entrée (CLK) et par un signal inversé de celui-ci (CLKN) pour charger et décharger le condensateur pendant chaque période du signal d'entrée ;
un moyen diviseur de tension divisant par deux la tension présente sur le condensateur (C1a, C1b) ;
au moins un comparateur (COMP1) détectant la tension divisée par deux et ayant une sortie couplée à la seconde entrée de la porte à deux entrées.

2. Doubleur de fréquence selon la revendication 1, dans lequel le moyen diviseur de tension est mis en oeuvre en utilisant deux condensateurs en série de même capacité (C1a, C1b) chargés et déchargés par le générateur de courant constant (I1) et les moyens de commutation (S1, S1a, S1b), le comparateur (COMP1) détectant la tension sur l'un (C1a) des deux condensateurs en série.

3. Doubleur de fréquence selon la revendication 1, **caractérisé en ce qu'**il comprend en outre :
un second condensateur (C2a, C2b), un second générateur de courant constant (I2) pour charger le second condensateur (C2a, C2b) pendant l'une des deux demi-périodes du signal d'entrée (CLK) et des troisième et quatrième moyens de commutation (S2, S2a, S2b) commandés en opposition de phase par le signal numérique d'entrée (CLK) et par une version inversée de celui-ci (CLKN) pour charger et décharger le second condensateur (C2a, C2b) à chaque période du signal d'entrée ;
un second moyen diviseur de tension divisant par deux la tension présente sur le second condensateur (C2a, C2b) ;
au moins un second comparateur (COMP2) détectant la tension divisée par deux et fournissant un signal logique de commande pour le moyen de commutation.
